# EUROPEAN PATENT SPECIFICATION

(11) **EP 3 650 584 B1**
(45) Date of publication and mention of the grant of the patent: **07.01.2026**
(21) Application number: 18205208.4
(22) Date of filing: 08.11.2018
(51) Int. Cl.: C23C 30/00, B23B 27/14, C23C 14/08, C23C 14/34, C23C 14/50, C23C 14/00

(54) **AN INDUSTRIAL PVD METHOD FOR PRODUCING A COATED CUTTING TOOL**
INDUSTRIELLE PVD-VERFAHREN ZUR HERSTELLUNG EINES BESCHICHTETEN SCHNEIDWERKZEUGS
PROCÉDÉ INDUSTRIEL DE PRODUCTION D'UN OUTIL DE COUPE REVÊTU PAR PVD

(43) Date of publication of application: 13.05.2020
(73) Proprietor: WALTER AG, 72072 Tübingen (DE)
(72) Inventor: DIECHLE, Dominic, DE-71083 Herrenberg (DE); SCHIER, Veit, 70771 Echterdingen (DE)
(74) Representative: Sandvik

(56) References cited:
- EP-A1- 0 744 473
- CN-A- 101 802 247
- US-A- 5 693 417
- US-A1- 2010 183 900
- US-B2- 8 540 786
- US-B2- 9 416 441
- PANJAN ET AL: "Sputtering simulation of multilayer coatings in industrial PVD system with three-fold rotation", VACUUM, PERGAMON PRESS, GB, vol. 82, no. 2, 15 October 2007 (2007-10-15), pages 158 - 161, XP022299595, ISSN: 0042-207X, DOI: 10.1016/J.VACUUM.2007.07.053

## Description

The present invention relates to a method for producing a coated cutting tool having a coating comprising aluminum oxide with a significant amount of alpha phase content. The present invention also relates to a coated cutting tool.

### Introduction

There is a continuous desire to improve cutting tools for metal machining so that they last longer, withstand higher cutting speeds and/or other increasingly demanding cutting operations. Commonly, a cutting tool for metal machining comprises a hard substrate material such as cemented carbide which has a thin hard coating usually deposited by either chemical vapour deposition (CVD) or physical vapour deposition (PVD).

Aluminium oxide (Al₂O₃) coatings are being used in coatings for cutting tools. The deposition of hard Al₂O₃ coatings in the industrial-scale PVD coaters is state of the art, but then only for gamma (γ) -Al₂O₃. The drawback of metastable Al₂O₃ phases like gamma (γ) or kappa (κ) is phase transformation into the thermodynamically stable alpha (α) -Al₂O₃ (corundum, R-3c) phase in a typical temperature range between 900°C and 1100°C. This limits the usage of metastable Al₂O₃ coatings in metal cutting applications to maximum temperatures below 900°C. At higher temperatures, the phase transformation takes place and the hardness, stress and volume of the metastable Al₂O₃ coatings change rapidly due to the heat evolved during metal cutting, resulting in cracks and flaking, and these coatings can't therefore be used in metal cutting applications. On the other hand, the usage of α-Al₂O₃ coatings in an as-deposited state, which is state of the art in CVD, is beneficial in high temperature cutting applications like e.g. turning.

The deposition of α-Al₂O₃ by PVD shows several advantages over CVD deposition methods. The α-Al₂O₃ deposition by CVD requires high temperatures in the range between 900°C to 1100°C and the coatings are having a tensile stress profile while lower temperatures are used in PVD processes. Furthermore, as-deposited PVD coatings typically have a residual stress being compressive, which is beneficial for providing high toughness which is necessary for milling applications, while CVD coatings typically have a residual stress being tensile.

A cutting tool with an Al₂O₃ coating of α-phase, or at least having a high content of α-phase, can thus be used at high temperature cutting applications, such as turning, while there is less beneficial to use Al₂O₃ coatings of γ- or κ-phase.

In order to produce a sufficient amount of coated cutting tools to be offered on the commercial market one has to be able to charge a PVD reactor with many uncoated blanks or substrates. Furthermore, in the case of commercial cutting tool inserts having rake and flank faces they should generally be coated on the whole insert, i.e., the coating should be deposited as evenly as possible on all sides of an insert.

The use of rotating carousels where uncoated blanks are mounted on for example pins provides for the production of a large number of coated inserts with an evenly distribution of a coating around the inserts. One mode of deposition is two-fold (2f) rotation where there is a first axis of rotation in the center of the whole carousel (table) and then a second axis of rotation by a number of rotating spindles which in its turn have (non-rotating) pins on which inserts are mounted. Another mode of deposition is three-fold (3f) rotation where there is a first axis of rotation in the center of the whole carousel (table) and then a second axis of rotation by a number of rotating spindles which in its turn have rotating pins on which inserts are mounted forming a third axis of rotation.

One consequence of deposition in a commercial 2f- or 3f- rotating mode is that the deposition of a coating will be repeatedly interrupted due to the rotation of the inserts. The rotation leads to that an area of an insert is either facing the plasma, or not facing the plasma, or being in some position partly facing the plasma. Furthermore, the distance to a target is varying during deposition as a result of the 2f- or 3f rotation. The above mentioned issues have prevented a commercial production of cutting tools with PVD alpha-aluminium oxide coatings.

Yamada-Takamura et al, Surface and Coatings Technology, 142-144 (2001) 260-264, discloses deposition of films containing α-Al₂O₃ by filtered arc deposition. However, the film starts with amorphous Al₂O₃ and nanocrystalline γ-Al₂O₃ followed by nucleation and subsequent growth of α-Al₂O₃. Furthermore, the arc-deposited film will contain a lot of droplets.

EP151707A1 discloses the formation of an α-Al₂O₃ coating where the temperature has to be raised to at least 800°C.

US2009/0214894A1 discloses formation of a coating comprising α-Al₂O₃ by first forming an oxide layer of corundum structure by oxidising a TiAlN, TiN or TiCN layer at a temperature of about 650-800°C and then depositing a layer comprising α-Al₂O₃, also at 650-800°C, by reactive sputtering.

However, when depositing a coating onto a cemented carbide substrate at high temperatures, such as 650°C, or higher, the substrate loses toughness which is a draw-back when designing a coated cutting tool. Furthermore, the use of template layers like chromium oxide or titanium oxide as templates for growing α-Al₂O₃ has substantial drawbacks since such template layers are mechanically weak and deteriorate the overall wear resistance of the whole coating during metal cutting.

US 8,540,786 B2 discloses a coating comprising α-Al₂O₃ oxide deposited by HIPIMS (High Power Impulse Magnetron Sputtering). In this disclosure, the substrate is constantly facing the magnetron sputtering glow discharge. Thus, no 2f- or 3f- rotation is used. No disclosure of any α-Al₂O₃ on both a rake and a flank face is disclosed.

EP0744473 A1 discloses a coated cutting tool with an alpha-alumina coating covering the flank and the rake face of the tool. US2010/183900 A1 also discloses a a coated cutting tool and a method wherein HilMPS methods are used to produce a coated cutting tool with enlarged service life.

It would therefore be beneficial in many metal cutting applications to use a cutting tool having a PVD α-Al₂O₃ containing coating and therefore further desired to provide a method for the efficient deposition of α-Al₂O₃ containing coatings by industrial-scale PVD at low substrate temperatures, with a high deposition rate, the α-Al₂O₃ containing coatings having high hardness, high Young's modulus, high crystallinity, residual stress being compressive, having high phase fractions of α-Al₂O₃, and being substantially droplet-free.

The object of the present invention is therefore to provide a method of producing, in industrial scale, a cutting tool having a coating comprising a PVD α-Al₂O₃.

### The invention

It has now been provided a method for producing a coated cutting tool which satisfies the above-mentioned objective. The method comprises HIPIMS deposition of α-phase containing Al₂O₃ coatings on two-fold (2f) and three-fold (3f) rotated substrates in industrial-scale PVD coaters for metal cutting industry with a high deposition rate and substrate temperatures below 600°C.

Thus, it is hereby provided a method for producing a coated cutting tool having at least one rake face and at least one flank face, the cutting tool comprising a substrate of cemented carbide, cermet, cBN, or ceramic and a coating, the method comprises depositing on every flank face and every rake face of the cutting tool an Al₂O₃ layer by a HIPIMS process, in the process the specific target peak pulse power density is ≥ 350 W/cm², the specific average target power density is ≥ 6 W/cm², the pulse time is 20-150 µs, the pulse frequency is ≥ 100 Hz, the peak pulse current is ≥ 400 A, the method comprising the following steps:
- charging a PVD reactor chamber, containing at least one Al target and a rotatable substrate holder, with cutting tool blanks,
- depositing an Al₂O₃ layer in the HIPIMS process during two-fold or three-fold rotation of the substrates, at a substrate temperature < 600°C,
the deposited Al₂O₃ layer comprises α-Al₂O₃.

The substrate temperature during the deposition in the HIPIMS process is ≥ 350°C but < 600°C, preferably ≥ 400°C but ≤ 580°C, most preferably ≥ 450°C but ≤ 560°C.

In the HIPIMS process the pulse time is suitably from 30 to 100 µs, preferably from 40 to 70 µs.

In the HIPIMS process the peak pulse cathode power is ≥ 500 kW, preferably ≥ 1 MW.

In the HIPIMS process the peak pulse current is preferably ≥ 600 A.

In the HIPIMS process the value of negative peak pulse voltage is ≥ 1200 V, preferably ≥ 1800 V.

In the HIPIMS process the pulse frequency is suitably ≥ 300 Hz, preferably ≥ 500 Hz.

In the HIPIMS process the oxygen partial pressure is ≥ 1x10⁻⁴ mbar, preferably ≥ 3x10⁻⁴ mbar.

In the HIPIMS process the total pressure is from 0.25 to 3 Pa, preferably from 0.5 to 1.5 Pa. The PVD reactor chamber gas comprises a noble gas element such as Ar which during operation of the HIPIMS process is ionised. If the total pressure is too low the noble gas element is more difficult to ionise and no plasma forms. If the total pressure is too high the noble gas element ions may be so many in the plasma that the average free path is too small hindering the transport of metal ions from the target to the substrate.

In the HIPIMS process the target size is from 500 to 3000 cm², preferably from 1000 to 2000 cm².

In the HIPIMS process the average cathode power is suitably ≥ 10 kW, preferably ≥ 15 kW.

In the HIPIMS process there is either a pulsed bias, or DC bias, voltage applied of from 150 to 300 V, preferably from 175 to 275 V, negative bias.

In the HIPIMS process the specific average target power density is suitably ≥ 8 W/cm², preferably ≥ 10 W/cm².

In the HIPIMS process the specific target peak pulse current density is suitably ≥ 0.25 A/cm², preferably ≥ 0.35 A/cm².

In the HIPIMS process the specific target peak pulse power density is suitably ≥ 650 W/cm².

In the HIPIMS process the peak bias current is ≥ 100 A and ≤ 800 A, preferably ≥ 200 A and ≤ 400 A.

In the HIPIMS process the specific bias current density is 5 - 80 mA/cm², preferably 10 - 40 mA/cm².

In one embodiment, two-fold (2f) rotated substrates is used in the HIPIMS process.

In one embodiment, three-fold (3f) rotated substrates is used in the HIPIMS process.

The substrate holder can be a rotatable table (i) which comprises rotatable spindles (ii) which in its turn each comprises a number or rotatable pins (iii). In two-fold (2f) rotation (i) and (ii) rotates while in three-fold (3f) rotation all of (i), (ii) and (iii) rotate.

The PVD reaction chamber suitably has a chamber volume of ≥ 800 l, preferably ≥ 1000 l.

In one embodiment, not a part of the present invention, the deposited aluminium oxide layer is an α-Al₂O₃ layer.

Two-fold (2f) and three-fold (3f) rotation of substrates lead to an interrupted deposition process due to the rotation of the substrates in the flow of elements in the plasma. Thus, the plasma density subjected to the substrates will vary to a great extent, from high levels down to very low levels. Despite this, significant amounts of α-phase of Al₂O₃ is deposited.

As a result of the method described herein an Al₂O₃ layer is provided in which an a-phase fraction on both a flank and rake face of 2f-, or even 3f-, rotated substrates is detected. It is especially noticeable that the production-like 3f- rotated substrates showed clear α-Al₂O₃ phase containing XRD signals on their flank and rake faces.

The method herein disclosed provides the following benefits: no usage of nucleation layer is needed, a low deposition temperature can be used so that the deterioration of substrate toughness is minimised, a full scale production equipment can be used, droplet-free coatings are provided, the deposition process provides a constant or increased α-Al₂O₃ phase fraction in the coating over time, hard α-Al₂O₃ containing coatings are provided with hardness ≥ 2000 HV.

In one embodiment the Al₂O₃ layer is deposited directly onto the substrate. This means that in this embodiment no other previously deposited layer is present between the Al₂O₃ layer and the substrate.

In a 2theta XRD analysis of the deposited Al₂O₃ layer the diffractogram shows at least clear peaks of α-Al₂O₃ (113) and α-Al₂O₃ (024). These peaks are, according to PDF no. 42-1468 of the ICDD database, positioned at 43.36 and 52.56 degrees 2theta respectively. When identifying diffraction peaks from an actual layer the peak positions in a diffractogram are often seen slightly shifted from PDF data due to, for example, internal stresses within the layer and equipment effects.

Thus, from XRD analysis one clearly sees that the deposited Al₂O₃ layer shows peaks from at least α-Al₂O₃ (113) and α-Al₂O₃ (024) in XRD analysis.

The thickness of the deposited Al₂O₃ layer is suitably from 0.1 to 20 µm, preferably from 0.5 to 10 µm.

In one embodiment the deposited Al₂O₃ layer contains a mixture of α-Al₂O₃ and γ-Al₂O₃.

In one embodiment a minimum of two or more reflections of α-Al₂O₃ are detectable in XRD analysis.

The deposited Al₂O₃ layer shows a relation between α-Al₂O₃ and γ-Al₂O₃ as follows:
In GIXRD (gracing incidence x-ray diffraction) analysis at 0.5° incidence angle the ratio l(α-Al₂O₃ (113)) to l(γ-Al₂O₃ (400)) is ≥ 0.5, preferably ≥ 1, most preferably ≥ 2, on at least one of the rake face or flank face of the cutting tool.
In GIXRD (gracing incidence x-ray diffraction) analysis at 0.5° incidence angle the ratio l(α-Al₂O₃ (024)) to l(γ-Al₂O₃ (400)) is ≥ 0.2, preferably ≥ 0.5, most preferably ≥ 1, on at least one of the rake face or flank face of the cutting tool.
In GIXRD (gracing incidence x-ray diffraction) analysis at 0.5° incidence angle the ratio l(α-Al₂O₃ (116)) to l(γ-Al₂O₃ (400)) is ≥ 0.1, preferably ≥ 0.2, most preferably ≥ 0.5, on at least one of the rake face or flank face of the cutting tool.

The deposited Al₂O₃ layer is suitably substantially droplet-free.

The deposited Al₂O₃ layer suitably has a Vickers hardness of ≥ 2000 HV, preferably from 2200 to 3000 HV, most preferably from 2600 to 3000 HV.

The deposited Al₂O₃ layer suitably has a reduced Young's modulus of ≥ 320 GPa, preferably from 330 to 420 GPa.

The coated cutting tool is a cutting tool for metal machining.

The coated cutting tool is in the form of an insert, a drill or an end mill.

The α-Al₂O₃ is present in the deposited Al₂O₃ layer on every rake face and every flank face of the cutting tool.

The present invention further relates to a coated cutting tool having at least one rake face and at least one flank face, comprising a substrate of cemented carbide, cermet, cBN, or ceramic and ceramic, and a coating comprising an Al₂O₃ layer deposited according to the method as herein disclosed.

The α-Al₂O₃ is present in the deposited Al₂O₃ layer on every rake face and flank face of the cutting tool.

The thickness of the Al₂O₃ layer is suitably from 0.1 to 20 µm, preferably from 0.5 to 10 µm.

The deposited Al₂O₃ layer contains a mixture of α-Al₂O₃ and γ-Al₂O₃.

The Al₂O₃ layer shows a relation between alpha-aluminium oxide and gamma-aluminium oxide as follows:
In GIXRD (gracing incidence x-ray diffraction) analysis at 0.5° incidence angle the ratio l(α-Al₂O₃ (113)) to l(γ-Al₂O₃ (400)) in an XRD 2theta diffractogram is ≥ 0.5, preferably ≥ 1, most preferably ≥ 2, on at least one of the rake face or flank face of the cutting tool.
In GIXRD (gracing incidence x-ray diffraction) analysis at 0.5° incidence angle the ratio l(α-Al₂O₃ (024)) to l(γ-Al₂O₃ (400)) in an XRD 2theta diffractogram is ≥ 0.2, preferably ≥ 0.5, most preferably ≥ 1, on at least one of the rake face or flank face of the cutting tool.
In GIXRD (gracing incidence x-ray diffraction) analysis at 0.5° incidence angle the ratio l(α-Al₂O₃ (116)) to l(γ-Al₂O₃ (400)) in an XRD 2theta diffractogram is ≥ 0.1, preferably ≥ 0.2, most preferably ≥ 0.5, on at least one of the rake face or flank face of the cutting tool.

The Al₂O₃ layer suitably has a Vickers hardness of ≥ 2000 HV, preferably from 2200 to 3000 HV, most preferably from 2600 to 3000 HV.

The Al₂O₃ layer suitably has a reduced Young's modulus of ≥ 320 GPa, preferably from 330 to 420 GPa.

The coated cutting tool is a cutting tool for metal machining.

The coated cutting tool is in the form of an insert, a drill or an end mill.

### Brief description of the drawings

Fig. 1 shows GIXRD measurements on an inventive coating with an incident angle of 1° of a 2f rotated rake face.
Fig. 2 shows GIXRD measurements on an inventive coating with an incident angle of 1° of a 2f rotated rake face
Fig. 3 shows GIXRD measurements on an inventive coating with an incident angle of 0.2° of a 2f rotated rake face
Fig. 4 shows GIXRD measurements on an inventive coating with an incident angle of 0.5° of a 3f rotated flank face

### Methods

### XRD-phase analysis:

The X-ray diffraction patterns concerning the phase analysis were acquired by Grazing incidence mode (GIXRD) on a diffractometer from Panalytical (Empyrean). CuKalpha-radiation with line focus was used for the analysis (high tension 40 kV, current 40 mA). The incident beam was defined by a 2 mm mask and a 1/8° divergence slit in addition with a X-ray mirror producing a parallel X-ray beam. The sideways divergence was controlled by a Soller slit (0,04°). For the diffracted beam path a 0,18° parallel plate collimator in conjunction with a proportional counter (0D-detector) was used. The measurement was done in grazing incidence mode (Omega = 1°). The 2Theta range was about 28-45° with a step size of 0,03° and a counting time of 10 s. For the XRD-line-profile analysis a reference measurement (with LaB6-powder) was done with the same parameters as listed above to correct for the instrumental broadening.

### Vickers hardness:

The Vickers hardness was measured by means of nano indentation (load-depth graph) using a Picodentor HM500 of Helmut Fischer GmbH, Sindelfingen, Germany. For the measurement and calculation the Oliver and Pharr evaluation algorithm was applied, wherein a diamond test body according to Vickers was pressed into the layer and the force-path curve was recorded during the measurement. The maximum load used was 15 mN (HV 0.0015), the time period for load increase and load decrease was 20 seconds each and the holding time (creep time) was 10 seconds. From this curve hardness was calculated. Hardness values and values for the reduced Young's modulus, indicated in the examples were each measured on the flank face of the coated tool.

### Reduced Young's modulus

The reduced Young's modulus (reduced modulus of elasticity) was determined by means of nano-indentation (load-depth graph) as described for determining the Vickers hardness.

### Thickness:

The thickness of the coating layers was determined by calotte grinding. Thereby a steel ball was used having a diameter of 30 mm for grinding the dome shaped recess and further the ring diameters were measured, and the layer thicknesses were calculated therefrom. Measurements of the layer thickness on the rake face (RF) of the cutting tool were carried out at a distance of 2000 µm from the corner, and measurements on the flank face (FF) were carried out in the middle of the flank face.

### Examples:

### Example 1 (invention):

On a WC-Co based cemented carbide substrate, having a Co content of 8 wt% and balance WC, an aluminium oxide coating was deposited in a Hauzer HTC1000 equipment under the following process conditions:
- Al target with size 830 mm x 170 mm,
- TruPlasma Highpulse 4002 generator of Trumpf Huettinger Sp. z o. o.,
- HIPIMS block shape mode,
- average cathode power 15 kW,
- total gas pressure approx. 1 Pa, 1260 sccm Ar gasflow, approx. 95 sccm O₂ gasflow,
- DC bias voltage 250 V, negative bias
- bias current 14.5 A at the end of process,
- substrate temperature 550°C,
- HIPIMS pulse time approx. 45 µs,
- HIPIMS DC charging voltage 2000 V (negative voltage),
- power supply peak voltage during pulse approx. 1650 V (negative voltage),
- power supply peak current during pulse approx. 680 A,
- HIPIMS pulse frequency approx. 680Hz,
- peak pulse cathode power approx. 1150 kW,
- coil current approx. 4.0 A,
- oxygen partial pressure approx. 5.1x10⁻⁴ mbar,
- process time 180 minutes

In 2f rotating mode an aluminium oxide coating having a thickness of 0.75 µm on the rake face and in 3f rotating mode an aluminium oxide coating having a thickness of 0.81 µm on the flank face was made.

The hardness was 2887 HV and the red. Young's modulus was 384 GPa.

### Examples 2-7:

Further Examples 2-7, using the same equipment as in Example 1, providing aluminium oxide coatings according to the invention were made where the process conditions had been varied according to Tables 1-4. Both 2f rotating and 3f rotating samples were produced.

**Table 1. Process conditions**

| **Example no.** | **O2 in sccm at begin** | **O2 in sccm after 30 min** | **O2 partial pressure in mbar** | **Ar in sccm** | **Temperature in °C** |
|---|---|---|---|---|---|
| 1 | 100 | 95 | 5.1x10^-4 | 1260 | 550 |
| 2 | 100 | 95 | 5.0x10^-4 | 1260 | 550 |
| 3 | 100 | 90 | 3.3x10^-4 | 1260 | 550 |
| 4 | 95 | 95 | 3.5x10^-4 | 1260 | 550 |
| 5 | 100 | 90 | 3.4x10^-4 | 1260 | 550 |
| 6 | 100 | 95 | 3.8x10^-4 | 1260 | 550 |
| 7 | 95 | 95 | 3.4x10^-4 | 1260 | 550 |

**Table 2. Process conditions cont.**

| **Example no.** | **Pressure in Pa** | **Coil in A** | **DC bias voltage in V** | **Bias in A at begin** | **Bias in A at end** | **Pulse length in µs** |
|---|---|---|---|---|---|---|
| 1 | 1.0 | 4.0 | -250 | 24.0 | 14.5 | 45 |
| 2 | 1.0 | 4.0 | -250 | 27.0 | 16.0 | 45 |
| 3 | 1.0 | 4.0 | -250 | 24.0 | 14.5 | 45 |
| 4 | 1.0 | 4.0 | -250 | 22.0 | 0.1 | 48 |
| 5 | 1.0 | 4.0 | -250 | 20.6 | 12.3 | 45 |
| 6 | 1.0 | 3.6 | -300 | 19.1 | 3.8 | 45 |
| 7 | 1.0 | 4.0 | -250 | 20.0 | 13.0 | 45 |

**Table 3. Process conditions cont.**

| **Example no.** | **Voltage* in V** | **Current in A** | **Power in kW** | **Frequency in Hz** | **DC voltage** in V** | **DC current in A** |
|---|---|---|---|---|---|---|
| 1 | -1650 | 680 | 15 | 680 | -2000 | 8.0 |
| 2 | -1655 | 627 | 15 | 742 | -2000 | 8.0 |
| 3 | -1640 | 700 | 15 | 670 | -2000 | 8.5 |
| 4 | -1670 | 650 | 15 | 650 | -2000 | 8.5 |
| 5 | -1615 | 768 | 15 | 617 | -2000 | 8.4 |
| 6 | -1600 | 850 | 15 | 566 | -2000 | 8.7 |
| 7 | -1420 | 620 | 15 | 850 | -1750 | 9.6 |

| | | | | | | |
|---|---|---|---|---|---|---|
| * used in the pulse ** charged voltage | | | | | | |

**Table 4. Process conditions cont.**

| **Example no.** | **Duty in %** | **Time in min.** | **U_{PeakMax} in V** | **I_{PeakMax} in A** | **P_{PeakMax} in kW** |
|---|---|---|---|---|---|
| 1 | 3.0 | 180 | -2000 | 680 | 1150 |
| 2 | 3.3 | 120 | -1990 | 626 | 1000 |
| 3 | 3.0 | 180 | -2005 | 720 | 1150 |
| 4 | 3.2 | 150 | -2000 | 650 | 1080 |
| 5 | 2.8 | 270 | -2000 | 768 | 1241 |
| 6 | 2.6 | 250 | -1995 | 860 | 1400 |
| 7 | 3.9 | 140 | -1670 | 605 | 840 |

Aluminium oxide coatings with thicknesses, hardnesses and red. Young's modulus according to Table 5 resulted from the depositions.

**Table 5.**

| **Example no.** | **Thickness 2f rake in µm** | **Hardness 2f rake in HV** | **Red. Young's modulus 2f in GPa** | **Thickness 3f flank in µm** | **Hardness 3f flank in HV** | **red. Young's modulus 3f flank in GPa** |
|---|---|---|---|---|---|---|
| 1 | 0.75 | 2887 | 384 | 0.81 | 2346 | 373 |
| 2 | 0.30 | 2443 | 412 | 0.45 | 2442 | 412 |
| 3 | 0.75 | 2857 | 401 | 0.66 | 2640 | 419 |
| 4 | 0.60 | 2691 | 386 | 0.62 | 2220 | 392 |
| 5 | 1.20 | 2641 | 351 | 1.16 | 2465 | 355 |
| 6 | 0.75 | 2519 | 359 | 0.85 | 2650 | 370 |
| 7 | 0.65 | 2496 | 370 | 0.46 | 2340 | 387 |

### Grazing incidence XRD (GIXRD) measurements:

GIXRD measurements in the 2theta range 35 to 60° of inventive examples no. 1-7 were made under an angle of 0.5° of a 3f rotated flank. The XRD diffractograms all show clearly α-Al₂O₃ (113), (024) and (116) peaks (43.363°, 52.559° and 57.504°, respectively, in PDF no. 42-1468 of the ICDD database). All diffractograms were found to show peaks of α-Al₂O₃ (113), (024) and (116).

Inventive example No. 1 was investigated further.

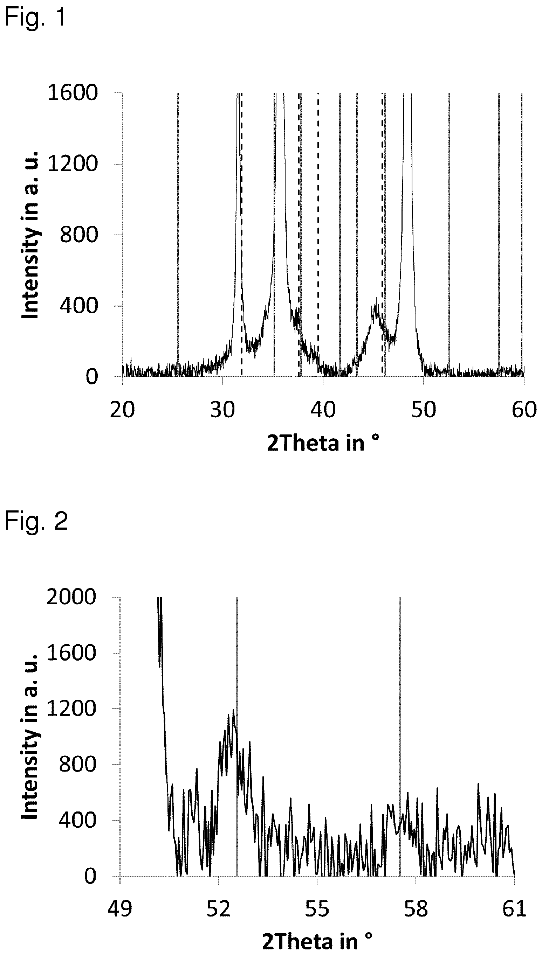

A GIXRD measurement in the 2theta range 20 to 60°, and a fine scan GIXRD measurement in the 2theta range 49 to 61°, were made on inventive example no. 1 with an incident angle of 1° of a 2f rotated rake face are shown in Figure 1 and Figure 2. Solid lines mark positions for α-Al₂O₃ and dashed lines mark positions for γ-Al₂O₃, according to PDF no. 42-1468 and PDF no. 10-425 of the ICDD database. The XRD diffractogram in Figure 1 shows clearly a γ-Al₂O₃ (400) peak (45.863° in PDF no. 10-425 of the ICDD database). Furthermore one sees weak α-Al₂O₃ (024) and (116) peaks (52.559° and 57.504°, respectively, in PDF no. 42-1468 of the ICDD database). Figure 2 shows an enlarged part of the 2theta range and here the α-Al₂O₃ (024) and (116) peaks are clearly seen.

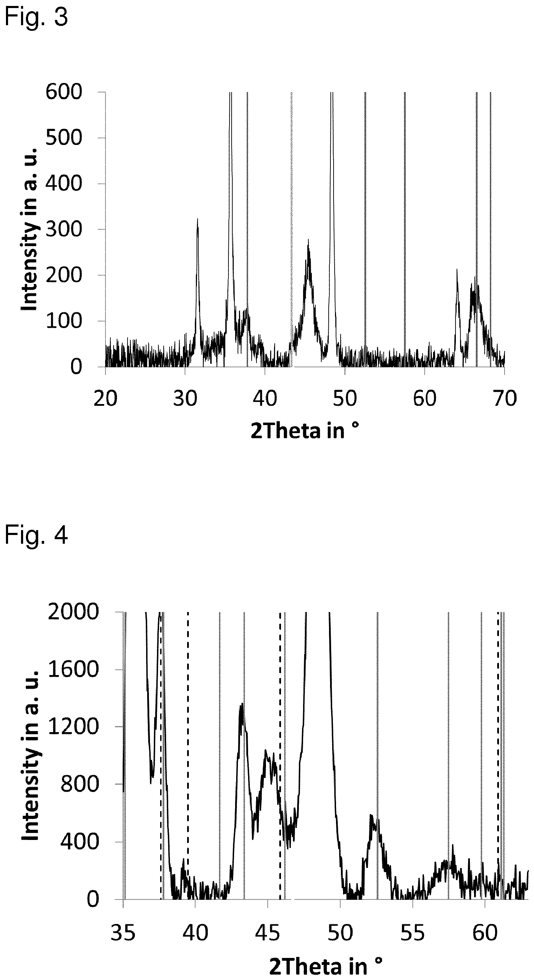

A GIXRD measurement in the 2theta range 20 to 70° of inventive example no. 1 was made under an angle of 0.2° of a 2f rotated rake face and is shown in Figure 3. Solid lines mark positions for α-Al₂O₃ according to PDF no. 42-1468 of the ICDD database. γ-Al₂O₃ peaks are also seen at positions according to PDF no. 10-425 but are not marked in the diffractogram. The smaller angle used in this GIXRD measurement gives a somewhat even more distinct caption of the γ-Al₂O₃ (400) peak (45.863°) but here the 2theta range has been extended so that also the γ-Al₂O₃ (440) peak is clearly seen (67.034° in PDF no. 10-425 of the ICDD database).

The conclusion of GIXRD of a 2f-rotated rake face of inventive example no.1 from Figures 1-3 is that the aluminium oxide layer contains α-Al₂O₃ in a mixture with γ-Al₂O₃ and the γ-phase dominates.

A GIXRD measurement in the 2theta range 35 to 62° of inventive example no. 1 was made under an angle of 0.5° of a 3f rotated flank and is shown in Figure 4. Solid lines mark positions for α-Al₂O₃ and dashed lines mark positions for γ-Al₂O₃, according to PDF no. 42-1468 and PDF no. 10-425 of the ICDD database. The XRD diffractogram shows clearly a γ-Al₂O₃ (400) peak (45.863°) and also a weak γ-Al₂O₃ (222) peak (39.492° in PDF no. 10-425 of the ICDD database). Furthermore one sees strong α-Al₂O₃ (113) and (024) peaks (43.363° and 52.559°, respectively, in PDF no. 42-1468 of the ICDD database).

The conclusion of GIXRD of a 3f-rotated flank face of inventive example no.1 from Figure 4 is that the aluminium oxide layer contains a high amount of α-Al₂O₃ in a mixture with γ-Al₂O₃.

From Figure 4 it is also concluded that in the GIXRD measurements of inventive example 1 under an angle of 0.5° of a 3f rotated flank face show that the ratio l(α-Al₂O₃ (113)) to l(γ-Al₂O₃ (400)) is about 1.4, the ratio l(α-Al₂O₃ (024)) to l(γ-Al₂O₃ (400)) is about 0.6 and the ratio l(α-Al₂O₃ (116)) to l(γ-Al₂O₃ (400)) is about 0.3.

### Example 9 (comparison):

On a WC-Co based cemented carbide substrate, having a Co content of 8 wt% and balance WC, an aluminium oxide coating was deposited in a Hauzer HTC1000 equipment using dual magnetron sputtering (DMS) 20 kW. The further process conditions were:
- Al target with size 830 mm x 170 mm,
- approx. 0.47 Pa Ar,
- target voltage control mode 480 V,
- DMS coil current 6.5 A,
- bias current 28.6 A

In 2f and 3f rotating mode an aluminium oxide coating having a thickness of approx. 1,2 µm was made. The hardness was 2792 HV and the red. Young's modulus was 340 GPa.

Only γ-Al₂O₃ peaks in XRD analysis were seen.

## Claims

1. A method for producing a coated cutting tool having at least one rake face and at least one flank face, the cutting tool comprising a substrate of cemented carbide, cermet, cBN, or ceramic and a coating,
the coated cutting tool is in the form of an insert, a drill or an endmill comprising an Al₂O₃ layer, the Al₂O₃ layer comprises α-Al₂O₃, wherein α-Al₂O₃ is present in the Al₂O₃ layer on every rake face and flank face of the cutting tool,
wherein the Al₂O₃ layer in GIXRD (gracing incidence x-ray diffraction) analysis at 0.5° incidence angle in an 2theta diffractogram, using CuKalpha-radiation, on at least one of the rake face or flank face of the cutting tool, shows:
a ratio l(α-Al₂O₃ (113)) to l(γ-Al₂O₃ (400)) in an XRD 2theta diffractogram being ≥ 0.5, preferably ≥ 1, most preferably ≥ 2, and/or
a ratio l(α-Al₂O₃ (024)) to l(γ-Al₂O₃ (400)) in an XRD 2theta diffractogram being ≥ 0.2, preferably ≥ 0.5, most preferably ≥ 1, and/or
a ratio l(α-Al₂O₃ (116)) to l(γ-Al₂O₃ (400)) in an XRD 2theta diffractogram being ≥ 0.1, preferably ≥ 0.2, most preferably ≥ 0.5,
in the GIXRD analysis peaks of α-Al₂O₃ (113), α-Al₂O₃ (024) and α-Al₂O₃ (116) in the diffractogram are, according to PDF no. 42-1468 of the ICDD database, positioned at 43.363 degrees, 52.559 degrees and 57.504 degrees 2theta, respectively, and a peak of γ-Al₂O₃ (400) in the diffractogram is, according to PDF no. 10-425 of the ICDD database, positioned at 45.863 degrees 2theta,
the method comprises depositing on every flank face and every rake face of the cutting tool an Al₂O₃ layer by a HIPIMS process, in the process the peak pulse cathode power is ≥ 500 kW, the value of negative peak pulse voltage is ≥ 1200 V, the specific target peak pulse power density is ≥ 350 W/cm², the specific average target power density is ≥ 6 W/cm², the pulse time is 20-150 µs, the pulse frequency is ≥ 100 Hz, the peak pulse current is ≥ 400 A, there is either a pulsed bias, or DC bias, voltage applied of from 150 to 300 V, negative bias, the peak bias current is ≥ 100 A and ≤ 800 A, the specific bias current density is 5 - 80 mA/cm², the oxygen partial pressure is ≥ 1x10⁻⁴ mbar, the total pressure is from 0.25 to 3 Pa, the method comprising the following steps:
- charging a PVD reactor chamber, containing at least one Al target and a rotatable substrate holder, with cutting tool blanks, the target size is from 500 to 3000 cm²,
- depositing an Al₂O₃ layer in the HIPIMS process during two-fold or three-fold rotation of the substrates, at a substrate temperature ≥ 350°C but < 600°C,
the deposited Al₂O₃ layer comprises α-Al₂O₃.

2. A method according to claim 1, wherein the substrate temperature during the deposition in the HIPIMS process is ≥ 400°C but ≤ 580°C.

3. A method according to any one of claims 1-2, wherein in the HIPIMS process the pulse time is from 30 to 100 µs.

4. A method according to any one of1 claims 1-3, wherein in the HIPIMS process the peak pulse cathode power is ≥ 1 MW.

5. A method according to any one of claims 1-4, wherein in the HIPIMS process the specific target peak pulse current density is ≥ 0.25 A/cm².

6. A method according to any one of claims 1-5, wherein in the HIPIMS process the specific target peak pulse power density is ≥ 650 W/cm².

7. A method according to any one of claims 1-6, wherein in the HIPIMS process the specific bias current density is 10 - 40 mA/cm².

8. A method according to any one of claims 1-7, wherein the deposited Al₂O₃ layer contains a mixture of α-Al₂O₃ and γ-Al₂O₃.

9. A coated cutting tool in the form of an insert, a drill or an endmill having at least one rake face and at least one flank face, comprising an Al₂O₃ layer deposited according to the method according to any one of claims 1-8, the deposited Al₂O₃ layer comprises α-Al₂O₃, wherein α-Al₂O₃ is present in the deposited Al₂O₃ layer on every rake face and flank face of the cutting tool,
wherein the Al₂O₃ layer in GIXRD (gracing incidence x-ray diffraction) analysis at 0.5° incidence angle in an 2theta diffractomgram, using CuKalpha-radiation, on at least one of the rake face or flank face of a cutting tool, shows:
a ratio I(α-Al₂O₃ (113)) to l(γ-Al₂O₃ (400)) in an XRD 2theta diffractogram being ≥ 0.5, preferably ≥ 1, most preferably ≥ 2, and/or
a ratio l(α-Al₂O₃ (024)) to I(γ-Al₂O₃ (400)) in an XRD 2theta diffractogram being ≥ 0.2, preferably ≥ 0.5, most preferably ≥ 1, and/or
a ratio l(α-Al₂O₃ (116)) to l(γ-Al₂O₃ (400)) in an XRD 2theta diffractogram being ≥ 0.1, preferably ≥ 0.2, most preferably ≥ 0.5,
in the GIXRD analysis peaks of α-Al₂O₃ (113), α-Al₂O₃ (024) and α-Al₂O₃ (116) in the diffractogram are, according to PDF no. 42-1468 of the ICDD database, positioned at 43.363 degrees, 52.559 degrees and 57.504 degrees 2theta, respectively, and a peak of γ-Al₂O₃ (400) in the diffractogram is, according to PDF no. 10-425 of the ICDD database, positioned at 45.863 degrees 2theta.

10. A coated cutting tool according to claim 9, wherein the Al₂O₃ layer has a Vickers hardness of ≥ 2000 HV.

11. A coated cutting tool according to any one of claims 9-10, wherein the Al₂O₃ layer has a reduced Young's modulus of ≥ 320 GPa.

## Patentansprüche

1. Verfahren zum Herstellen eines beschichteten Schneidwerkzeugs, das mindestens eine Spanfläche und mindestens eine Freifläche aufweist, wobei das Schneidwerkzeug ein Substrat aus Hartmetall, Cermet, cBN, oder Keramik und eine Beschichtung umfasst, das Beschichtetes Schneidwerkzeug ist in Form eines Einsatzes, eines Bohrers oder eines Schaftfräsers das eine Al₂O₃-Schicht umfasst, wobei die Al₂O₃-Schicht α-Al₂O₃ umfasst, wobei α-Al₂O₃ in der Al₂O₃-Schicht auf jeder Spanfläche und Freifläche des Schneidwerkzeugs vorhanden ist,
wobei die Al₂O₃-Schicht in einer GIXRD(Grazing Incidence X-Ray Diffraction)-Analyse unter einem Einfallswinkel von 0,5° in einem 2-Theta-Diffraktogramm unter Verwendung von CuKalpha-Strahlung an mindestens einer von der Spanfläche oder der Freifläche eines Schneidwerkzeugs **dadurch gekennzeichnet, ist, dass** sie Folgendes aufweist:
ein Verhältnis I(α-Al₂O₃ (113)) zu I(γ-Al₂O₃ (400)) in einem XRD-2-Theta-Diffraktogramm von ≥ 0,5, vorzugsweise ≥ 1, am meisten bevorzugt ≥ 2, und/oder
ein Verhältnis I(α-Al₂O₃ (024)) zu I(γ-Al₂O₃ (400)) in einem XRD-2-Theta-Diffraktogramm von ≥ 0,2, vorzugsweise ≥ 0,5, am meisten bevorzugt ≥ 1, und/oder
ein Verhältnis I(α-Al₂O₃ (116)) zu I(γ-Al₂O₃ (400)) in einem XRD-2-Theta-Diffraktogramm von ≥ 0,1, vorzugsweise ≥ 0,2, am meisten bevorzugt ≥ 0,5,
wobei, in der GIXRD-Analyse, Peaks von α-Al₂O₃ (113), α-Al₂O₃ (024) und α-Al₂O₃ (116) in dem Diffraktogramm, gemäß PDF Nr. 42-1468 der ICDD-Datenbank, jeweils bei 43,363 Grad, 52,559 Grad und 57,504 Grad 2Theta positioniert sind, und ein Peak von γ-Al₂O₃ (400) in dem Diffraktogramm, gemäß PDF Nr. 10-425 der ICDD-Datenbank, bei 45,863 Grad 2Theta positioniert ist,
wobei das Verfahren ein Abscheiden einer Al₂O₃-Schicht auf jeder Freifläche und jeder Spanfläche des Schneidwerkzeugs durch einen HIPIMS-Prozess umfasst, wobei in dem Prozess die Kathoden-Pulsspitzenleistung ≥ 500 kW ist, der Wert der negativen Pulsspitzenspannung ≥ 1200 V ist, die spezifische Dichte der Target-Pulsspitzenleistung ≥ 350 W/cm² ist, die spezifische durchschnittliche Dichte der Targetleistung ≥ 6 W/cm² ist, die Pulszeit 20-150 µs beträgt, die Pulsfrequenz ≥ 100 Hz ist, der Pulsspitzenstrom ≥ 400 A ist, entweder eine gepulste Vorspannung oder eine Gleichstromvorspannung von 150 bis 300 V negativer Vorspannung angelegt wird, der Spitzenvorspannungsstrom ≥ 100 A und ≤ 800 A ist, die spezifische Vorspannungsstromdichte 5-80 mA/cm² beträgt, der Sauerstoffpartialdruck ≥ 1x10⁻⁴ mbar ist, der Gesamtdruck 0,25 bis 3 Pa beträgt, wobei das Verfahren die folgenden Schritte umfasst:
- Beschicken einer PVD-Reaktorkammer, die mindestens ein Al-Target und einen drehbaren Substrathalter mit Schneidwerkzeugrohlingen enthält, wobei die Targetgröße 500 bis 3000 cm² beträgt,
- Abscheiden einer Al₂O₃-Schicht in dem HIPIMS-Prozess während einer zweifachen oder dreifachen Rotation der Substrate bei einer Substrattemperatur ≥ 350 °C, aber < 600 °C, wobei die abgeschiedene Al₂O₃-Schicht α-Al₂O₃ umfasst.

2. Verfahren nach Anspruch 1, wobei die Substrattemperatur während der Abscheidung in dem HIPIMS-Prozess ≥ 400 °C, aber ≤ 580 °C ist.

3. Verfahren nach einem der Ansprüche 1-2, wobei die Pulszeit in dem HIPIMS-Prozess 30 bis 100 µs beträgt.

4. Verfahren nach einem der Ansprüche 1-3, wobei die Kathoden-Pulsspitzenleistung in dem HIPIMS-Prozess ≥ 1 MW ist.

5. Verfahren nach einem der Ansprüche 1-4, wobei die spezifische Dichte des Target-Pulsspitzenstroms in dem HIPIMS-Prozess ≥ 0,25 A/cm² ist.

6. Verfahren nach einem der Ansprüche 1-5, wobei die spezifische Dichte der Target-Pulsspitzenleistung in dem HIPIMS-Prozess ≥ 650 W/cm² ist.

7. Verfahren nach einem der Ansprüche 1-6, wobei die spezifische Vorspannungsstromdichte in dem HIPIMS-Prozess 10-40 mA/cm² beträgt.

8. Verfahren nach einem der Ansprüche 1-7, wobei die abgeschiedene Al₂O₃-Schicht eine Mischung aus α-Al₂O₃ und γ-Al₂O₃ enthält.

9. Beschichtetes Schneidwerkzeug in Form eines Einsatzes, eines Bohrers oder eines Schaftfräsers mit mindestens einer Spanfläche und mindestens einer Freifläche, mindestens eine Al₂O₃-Schicht umfassend, die gemäß dem Verfahren nach einem der Ansprüche 1-8 abgeschieden wurde, wobei die abgeschiedene Al₂O₃-Schicht α-Al₂O₃ umfasst, wobei α-Al₂O₃ in der abgeschiedenen Al₂O₃-Schicht auf jeder Spanfläche und Freifläche des Schneidwerkzeugs vorhanden ist,
wobei die Al₂O₃-Schicht in einer GIXRD(Grazing Incidence X-Ray Diffraction)-Analyse unter einem Einfallswinkel von 0,5° in einem 2-Theta-Diffraktogramm unter Verwendung von CuKalpha-Strahlung an mindestens einer von der Spanfläche oder der Freifläche eines Schneidwerkzeugs **dadurch gekennzeichnet, ist, dass** sie Folgendes aufweist:
ein Verhältnis I(α-Al₂O₃ (113)) zu I(γ-Al₂O₃ (400)) in einem XRD-2-Theta-Diffraktogramm von ≥ 0,5, vorzugsweise ≥ 1, am meisten bevorzugt ≥ 2, und/oder
ein Verhältnis I(α-Al₂O₃ (024)) zu I(γ-Al₂O₃ (400)) in einem XRD-2-Theta-Diffraktogramm von ≥ 0,2, vorzugsweise ≥ 0,5, am meisten bevorzugt ≥ 1, und/oder
ein Verhältnis I(α-Al₂O₃ (116)) zu I(γ-Al₂O₃ (400)) in einem XRD-2-Theta-Diffraktogramm von ≥ 0,1, vorzugsweise ≥ 0,2, am meisten bevorzugt ≥ 0,5,
wobei, in der GIXRD-Analyse, Peaks von α-Al₂O₃ (113), α-Al₂O₃ (024) und α-Al₂O₃ (116) in dem Diffraktogramm, gemäß PDF Nr. 42-1468 der ICDD-Datenbank, jeweils bei 43,363 Grad, 52,559 Grad und 57,504 Grad 2Theta positioniert sind, und ein Peak von γ-Al₂O₃ (400) in dem Diffraktogramm, gemäß PDF Nr. 10-425 der ICDD-Datenbank, bei 45,863 Grad 2Theta positioniert ist.

10. Beschichtetes Schneidwerkzeug nach Anspruch 9, wobei die Al₂O₃-Schicht eine Vickers-Härte von ≥ 2000 HV aufweist.

11. Beschichtetes Schneidwerkzeug nach einem der Ansprüche 9-10, wobei die Al₂O₃-Schicht einen reduzierten Elastizitätsmodul von ≥ 320 GPa aufweist.

## Revendications

1. Procédé de production d'un outil de coupe revêtu ayant l'au moins une face de coupe et l'au moins une face de dépouille, l'outil de coupe comprenant un substrat de carbure cémenté, cermet, cBN, ou céramique et un revêtement, l'outil de coupe revêtu sous la forme d'une plaquette, d'un foret ou d'une fraise comprenant une couche d'Al₂O₃, la couche d'Al₂O₃ comprend α-Al₂O₃ dans lequel α-Al₂O₃ est présent dans la couche d'Al₂O₃ sur chaque face de coupe et face de dépouille de l'outil de coupe, dans lequel la couche d'Al₂O₃ est analysée dans une analyse GIXRD (diffraction des rayons X à incidence rasante) selon un angle d'incidence de 0,5° dans un diffractomgramme 2thêta, à l'aide d'un rayonnement CuKalpha, sur au moins l'une de la face de coupe ou de la face de dépouille d'un outil de coupe, **caractérisé en ce qu'**il présente :
un rapport l(α-Al₂O₃ (113)) - l(γ-Al₂O₃ (400)) dans un diffractogramme XRD 2thêta qui est ≥ 0,5, de préférence ≥ 1, le plus préférablement ≥ 2, et/ou
un rapport l(α-Al₂O₃ (024)) - l(γ-Al₂O₃ (400)) dans un diffractogramme XRD 2thêta qui est ≥ 0,2, de préférence ≥ 0,5, le plus préférablement ≥ 1, et/ou
un rapport l(α-Al₂O₃ (116)) to l(γ-Al₂O₃ (400)) dans un diffractogramme XRD 2thêta qui est ≥ 0,1, de préférence ≥ 0,2, le plus préférablement ≥ 0,5,
dans l'analyse GIXRD des pics d'α-Al₂O₃ (113), d'α-Al₂O₃ (024) et d'α-Al₂O₃ (116) dans le diffractogramme sont, selon PDF n° 42-1468 de la base de données ICDD, positionnés à 43,363 degrés, 52,559 degrés et 57,504 degrés 2thêta, respectivement, et un pic de γ-Al₂O₃ (400) dans le diffractogramme est, selon PDF n° 10-425 de la base de données ICDD, positionné à 45,863 degrés 2thêta,
le procédé comprend le dépôt sur chaque face de dépouille et chaque face de coupe de l'outil de coupe d'une couche d'Al₂O₃ par un processus HIPIMS, dans le processus, la puissance de crête d'impulsion de cathode est ≥ 500 kW, la valeur de tension de crête d'impulsion négative est ≥ 1200 V, la densité de puissance de crête d'impulsion cible spécifique est ≥ 350 W/cm², la densité de puissance cible moyenne spécifique est ≥ 6 W/cm², le temps d'impulsion est de 20-150 µs, la fréquence d'impulsion est ≥ 100 Hz, le courant de crête d'impulsion est ≥ 400 A, il existe une tension à polarisation pulsée ou à polarisation CC appliquée de 150 à 300 V, une polarisation négative, le courant de crête de polarisation est ≥ 100 A et ≤ 800 A, la densité de courant de polarisation spécifique est de 5 à 80 mA/cm², la pression partielle d'oxygène est ≥ 1x10⁻⁴ mbar, la pression totale est de 0,25 à 3 Pa, le procédé comprenant les étapes suivantes :
- le chargement d'une chambre de réacteur PVD, contenant l'au moins une cible en Al et un dispositif de maintien de substrat rotatif, avec des ébauches d'outil de coupe, la taille cible est de 500 à 3 000 cm²,
- le dépôt d'une couche d'Al₂O₃ dans le processus HIPIMS pendant une rotation double ou triple des substrats, à une température de substrat ≥ 350 °C, mais < 600 °C, la couche d'Al₂O₃ déposée comprend α-Al₂O₃.

2. Procédé selon la revendication 1, dans lequel la température de substrat pendant le dépôt dans le processus HIPIMS est ≥ 400 °C, mais ≤ 580 °C.

3. Procédé selon l'une quelconque des revendications 1 et 2, dans lequel, dans le processus HIPIMS, le temps d'impulsion est de 30 à 100 µs.

4. Procédé selon l'une quelconque des revendications 1 à 3, dans lequel, dans le processus HIPIMS, la puissance de crête d'impulsion de cathode est ≥ 1 MW.

5. Procédé selon l'une quelconque des revendications 1 à 4, dans lequel, dans le processus HIPIMS, la densité de courant de crête d'impulsion cible spécifique est ≥ 0,25 A/cm².

6. Procédé selon l'une quelconque des revendications 1 à 5, dans lequel, dans le processus HIPIMS, la densité de puissance de crête d'impulsion cible spécifique est ≥ 650 W/cm².

7. Procédé selon l'une quelconque des revendications 1 à 6, dans lequel, dans le processus HIPIMS, la densité de courant de polarisation spécifique est de 10 à 40 mA/cm².

8. Procédé selon l'une quelconque des revendications 1 à 7, dans lequel, la couche d'Al₂O₃ déposée, contient un mélange d'α-Al₂O₃ et de γ-Al₂O₃.

9. Outil de coupe revêtu sous la forme d'une plaquette, d'un foret ou d'une fraise à queue ayant l'au moins une face de coupe et l'au moins une face de dépouille, comprenant une couche d'Al₂O₃ déposée selon le procédé selon l'une quelconque des revendications 1 à 8, la couche d'Al₂O₃ déposée comprend α-Al₂O₃, dans lequel α-Al₂O₃ est présent dans la couche d'Al₂O₃ déposée sur chaque face de coupe et face de dépouille de l'outil de coupe, dans lequel la couche d'Al₂O₃ est analysée dans une analyse GIXRD (diffraction des rayons X à incidence rasante) selon un angle d'incidence de 0,5° dans un diffractomgramme 2thêta, à l'aide d'un rayonnement CuKalpha, sur au moins l'une de la face de coupe ou de la face de dépouille d'un outil de coupe, **caractérisé en ce qu'**il présente :
un rapport l(α-Al₂O₃ (113)) - l(γ-Al₂O₃ (400)) dans un diffractogramme XRD 2thêta qui est ≥ 0,5, de préférence ≥ 1, le plus préférablement ≥ 2, et/ou
un rapport l(α-Al₂O₃ (024)) - l(γ-Al₂O₃ (400)) dans un diffractogramme XRD 2thêta qui est ≥ 0,2, de préférence ≥ 0,5, le plus préférablement ≥ 1, et/ou
un rapport l(α-Al₂O₃ (116)) to l(γ-Al₂O₃ (400)) dans un diffractogramme XRD 2thêta qui est ≥ 0,1, de préférence ≥ 0,2, le plus préférablement ≥ 0,5,
dans l'analyse GIXRD des pics d'α-Al₂O₃ (113), d'α-Al₂O₃ (024) et d'α-Al₂O₃ (116) dans le diffractogramme sont, selon PDF n° 42-1468 de la base de données ICDD, positionnés à 43,363 degrés, 52,559 degrés et 57,504 degrés 2thêta, respectivement, et un pic de γ-Al₂O₃ (400) dans le diffractogramme est, selon PDF n° 10-425 de la base de données ICDD, positionné à 45,863 degrés 2thêta.

10. Outil de coupe revêtu selon la revendication 9, dans lequel la couche d'Al₂O₃ a une dureté Vickers de ≥ 2 000 HV.

11. Outil de coupe revêtu selon l'une quelconque des revendications 9 et 10, dans lequel la couche d'Al₂O₃ a un module de Young réduit de ≥ 320 GPa.
